Europäisches Patentamt

European Patent Office

Office européen des brevets

(11) Publication number : **0 488 643 A2**

(12) # EUROPEAN PATENT APPLICATION

(21) Application number : 91310870.0

(22) Date of filing : 26.11.91

(51) Int. Cl.[5] : **G09G 3/36**

(30) Priority : 26.11.90 JP 323695/90
10.12.90 JP 415721/90

(43) Date of publication of application :
03.06.92 Bulletin 92/23

(84) Designated Contracting States :
DE FR GB

(71) Applicant : **SEL SEMICONDUCTOR ENERGY
LABORATORY CO., LTD.**
**398 Hase**
**Atsugi-shi Kanagawa-ken 243 (JP)**

(72) Inventor : **Yamazaki, Shunpei**
**21-21, Kitakarasuyama, 7-chome**
**Setagaya-ku, Tokyo 157 (JP)**
Inventor : **Mase, Akira**
**3-3, 381-1, Hase**
**Atsugi-shi, Kanagawa-ken 243 (JP)**
Inventor : **Hiroki, Masaaki**
**533-13, Shirane**
**Isehara-shi, Kanagawa-ken 259-11 (JP)**

(74) Representative : **Milhench, Howard Leslie et al**
**R.G.C. Jenkins & Co. 26 Caxton Street**
**London SW1H 0RJ (GB)**

(54) **Electro-optical device and driving method for the same.**

(57) A grey tone display and a driving method for the display are described. The display comprises a light influencing layer, an electrode pad located adjacent to the layer at one side of the layer in order to define a pixel in the layer, an n-channel field effect transistor connected to the electrode pad at its source terminal, a p-channel field effect transistor connected to the electrode pad at its source terminal, a first control line connected to the drain terminal of the n-channel field effect transistor, a second control line connected to the drain terminal of the p-channel field effect transistor, a third control line connected to the gate terminals of the n-channel field effect transistor and the p-channel field effect transistor, and a control circuit for supplying control signals to the first, second and third control lines. By virtue of this configuration, the voltage of the electrode pad can be arbitrarily controlled by adjusting the input levels at the gate terminals.

FIG. 1

EP 0 488 643 A2

BACKGROUND OF THE INVENTION

Field of the Invention

The present invention relates to a grey tone display and a driving method for the same and, more particularly though not exclusively to a display driving system utilizing complementary thin-film insulated-gate field effect transistors suitable for use in liquid crystal displays.

Description of the Prior Art

Active liquid crystal displays which are driven by thin-film transistors (TFTs) are well known in the art. Displays of this type comprise visual panels and peripheral circuits for driving the panels. A peripheral circuit is formed by attaching a single crystalline chip containing integrated circuits to a glass substrate by tab-bonding or COG (chip on glass). A visual panel comprises a plurality of pixels, each pixel being provided with a driving TFT. The TFT is usually an n-channel FET formed within an amorphous or polycrystalline semiconductor film which is electrically coupled to a respective pixel.

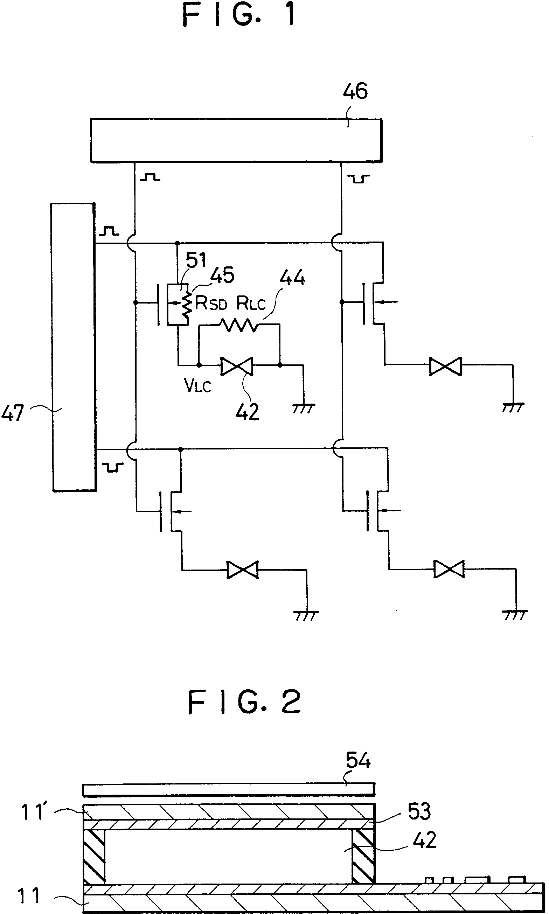

Fig. 1 is a diagram illustrating the equivalent circuit of an exemplary liquid crystal display. The diagram shows only a 2 x 2 matrix for the sake of convenience of description, whereas ordinary liquid crystal displays commonly consist of much greater numbers of pixels for example a 640 x 480 pixel matrix, a 1260 x 960 pixel matrix and so on. The liquid crystal display includes a liquid crystal layer 42 disposed between a pair of glass substrates 11 and 11' as shown in Fig. 2. Numeral 54 designates a polarizing plate. The inner surface of the glass substrate 11' is coated with a ground electrode 53. The inner surface of the other substrate 11 is provided with a plurality of conductive pads each constituting one pixel of the display. Each conductive pad is formed together with an n-channel FET 51 whose source is electrically connected to the corresponding pad. The drains of all the FETs in the same row of the matrix are connected to a common control line for the row to which control signals are supplied from a row driver 47. The gates of all the n-channel FETs in the same column are connected to a common control line for the column to which control signals are supplied from a column driver 46.

In operation of the thus described display, the column driver 46 supplies control signals of a high voltage level to selected columns to turn on the TFTs of those columns. There are, however, undesirable cases in which the switching action of the TFTs cannot sufficiently be carried out so that the output voltage of the TFT (i.e. the input to the pixel) does not reach a predetermined high voltage level (e.g. 5V), or the output voltage does not drop sufficiently to reach a predetermined low voltage level (e.g. 0V). This is because of the asymmetrical characteristics of the TFTs. Namely, the charging action on the liquid crystal layer takes place in a dissimilar manner to the discharging action therefrom. Furthermore, since the liquid crystal layer is intrinsically insulating, the liquid crystal voltage (VLC) floats when the TFT is turned off. The amount of electric charge accumulated on the liquid crystal layer which is equivalent to a capacitance, determines the VLC. The accumulated charge, however, will leak through a channel resistance RSD which may be formed by dust or ionized impurities or through the liquid crystal itself whose resistance RLC 44 may occasionally be reduced. For this reason, VLC sometimes becomes at an indeterminate intermediate voltage level. In the case of a display panel having from, say, two hundred thousand to 5 million pixels, a high yield cannot be expected in such a situation.

Also, in conventional driving methods, the liquid crystal material to which control voltages are applied are subjected to an average electric field in one direction during operation. The electric field tends to cause electrolysis when continuously used. Because of this, the aging of the liquid crystal material is accelerated and the working life of the display is reduced.

Furthermore, it has been difficult to realize grey tone displays without a complicated structure, capable of arbitrarily displaying a variety of visual images in various shades of grey.

OBJECTS AND SUMMARY OF THE INVENTION

It is an object of the present invention to provide a grey tone display and a driving method for the same which is capable of demonstrating clear visual images.

It is another object of the present invention to provide a grey tone display and a driving method for the same which is capable of accurate operation.

It is a further object of the present invention to provide a grey tone display and a driving method for the same which is capable of arbitrarily displaying a variety of visual images in various shades of grey.

To achieve the foregoing and other objects, the present invention, in one of its aspects, provides a display which comprises a light influencing medium, electrodes defining a plurality of pixels in the medium, and a control circuit for supplying control signals to the electrodes, the control circuit supplying the control signal to each pixel through a switching element which comprises at least one complementary transistor pair connected between a low voltage level and a high voltage level. By use of complementary transistors, the voltage level of each pixel during its operation can be prevented from fluctuating.

More particularly, the complementary transistors are coupled in series at their source terminals to form the output terminal of the complementary transistor pair. The input terminal of the complementary transistor pair is formed by their gate terminals being coupled to each other. By virtue of this construction, when the complementary transistors are connected between a suitable high voltage and a suitable low voltage, the output terminal of the complementary transistor pair is brought to the input voltage level at its gate terminals from which the threshold voltage is subtracted. Accordingly, the voltage applied to the light influencing medium can be arbitrarily adjusted by regulating the input voltage level resulting in visual images capable of various shades of grey. This is particularly appropriate for light influencing mediums comprising dispersion type liquid crystals whose thresholds may take a certain range of values.

In typical driving methods, a display of this type is driven by applying control signals in the form of pulses to conductive pads. The light influencing medium is disposed between the conductive pads and a back electrode. The back electrode is supplied with an alternating voltage in order to make the average voltage applied to the light influencing medium equal to zero volts.

In a typical example, the present invention is applied to the field of liquid crystal displays (LCDs). Each pixel of the display is provided with a switching element comprising complementary thin-film field effect transistors which forcibly pull or push the voltage level of the liquid crystal layer to a definite high or low value rather than leaving it in a floating state. Of course, the present invention can also be implemented with a variety of other types of transistor, such as staggered types, coplanar types, inverted staggered types and inverted coplanar types. The channel regions of the transistors may be doped by the introduction of a suitable impurity which reduces the photosensitivity of the transistors, in order to eliminate the undesirable influence of incident light. When the control transistors of a driver for supplying control signals to the switching transistors are formed also on the same substrate at its peripheral position where no light is incident, they are not spoiled by the impurity. In such a case, two types of transistors are formed on the substrate, one being doped and the other not being doped and having a carrier mobility 2 to 4 times greater than that of the spoiled transistors.

The above and further features of the present invention are set forth with particularity in the appended claims and will become clear to those possessed of appropriate knowledge and skills from consideration of the following description given with reference to the accompanying drawings.

## BRIEF DESCRIPTION OF THE DRAWINGS

Fig. 1 is a schematic diagram showing the equivalent circuit of a prior art liquid crystal display;

Fig. 2 is a cross-sectional schematic view showing the general configuration of a prior art liquid crystal display;

Fig. 3 is a schematic diagram showing the equivalent circuit of a liquid crystal display in accordance with a first embodiment of the present invention;

Figs. 4(A), 4(B) and 4(C) are plan and cross-sectional schematic views showing the liquid crystal display illustrated in Fig. 3;

Figs. 5(A) and 5(B) are explanatory diagrams demonstrating operation of the liquid crystal display in accordance with the first embodiment;

Fig. 6 is a schematic view showing a system suitable for manufacturing thin-film field effect semiconductor transistors in accordance with the present invention;

Fig. 7(A) is a schematic view showing a planar type magnetron RF sputtering apparatus of the system illustrated in Fig. 6 suitable for use in depositing oxide and semiconductor films;

Fig. 7(B) is an explanatory diagram showing the arrangement of magnets provided in the apparatus illustrated in Fig. 7(A);

Figs. 8(A) to 8(F) are cross-sectional schematic views showing a method of manufacturing thin-film field effect semiconductor transistors suitable for the first embodiment of the present invention;

Fig. 9(A) is a schematic diagram showing the equivalent circuit of a liquid crystal display in accordance with a second embodiment of the present invention;

Fig. 9(B) is a schematic plan view showing the liquid crystal display illustrated in Fig. 9(A);

Fig. 10(A) is a schematic diagram showing the equivalent circuit of a liquid crystal display in accordance with a third embodiment of the present invention;

Fig. 10(B) is a schematic plan view showing the liquid crystal display illustrated in Fig. 10(A);

Fig. 11 is a schematic diagram showing the equivalent circuit of a liquid crystal display in accordance with a fourth embodiment of the present invention;

Fig. 12 is an explanatory diagram showing the signals involved in the operation of the complementary transistors of the liquid crystal display in accordance with the fourth embodiment;

Fig. 13 is a signal timing diagram demonstrating the operation of the liquid crystal display in accordance with the fourth embodiment of the present invention;

Fig. 14 is a schematic diagram showing the equivalent circuit of a liquid crystal display corresponding to Fig. 13 in accordance with the fourth embodiment of the present invention;

Fig. 15 is a schematic diagram showing the equivalent circuit of a liquid crystal display in accordance with a fifth embodiment of the present invention;

Fig. 16 is a signal timing diagram demonstrating the operation of the liquid crystal display in accordance with the fifth embodiment of the present invention;

Fig. 17 is a schematic diagram showing the equivalent circuit of a liquid crystal display in accordance with a sixth embodiment of the present invention; and

Fig. 18 is a signal timing diagram demonstrating operation of the liquid crystal display in accordance with the sixth embodiment of the present invention.

## DETAILED DESCRIPTION OF THE EMBODIMENTS

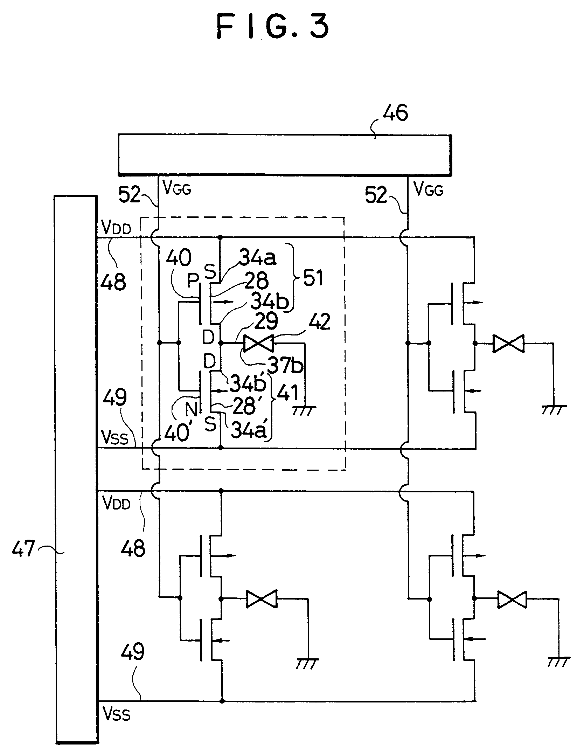

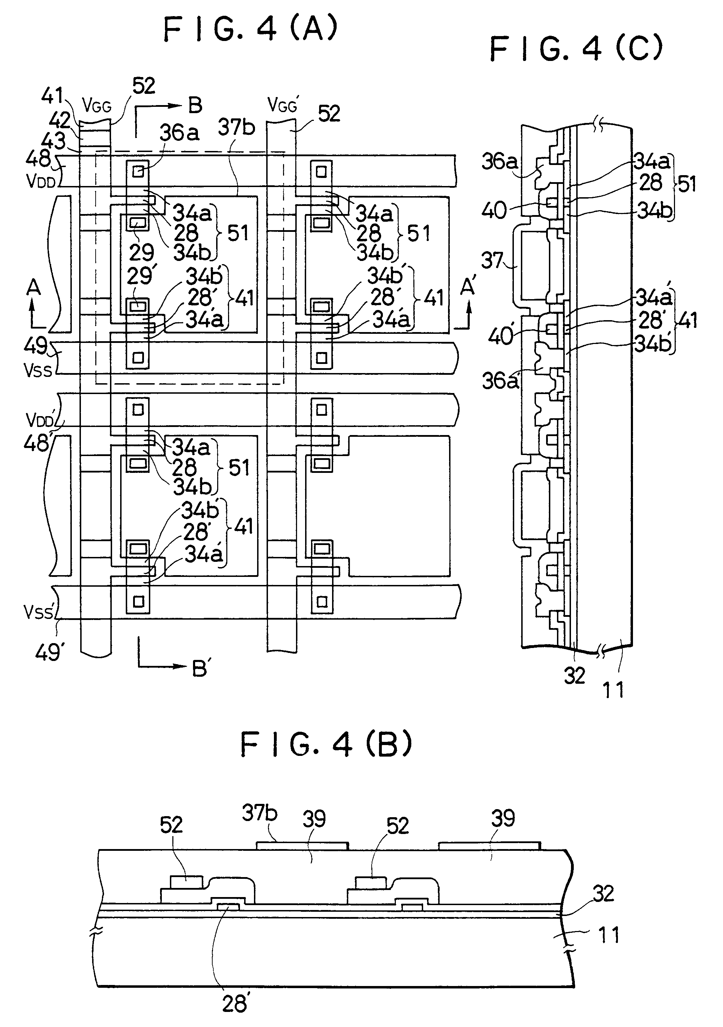

Fig. 3 is a diagram illustrating the equivalent circuit of a liquid crystal display in accordance with a first embodiment of the present invention. The diagram shows only a 2 x 2 matrix for the sake of convenience of description, whereas ordinary liquid crystal displays commonly consist of much greater numbers of pixels such as a 640 x 480 matrix or a 1260 x 960 matrix. The liquid crystal display includes a liquid crystal layer 42 disposed between a pair of glass substrates 11 and 11' as shown in Fig. 2. The inner surface of the glass substrate 11' is coated with an electrode 53. The inner surface of the other substrate 11 is provided with a plurality of conductive pads 37b each constituting one pixel of the display as seen from Fig. 4(A). The dashed line encloses one pixel in the figure. Each conductive pad 37b is formed on the substrate together with two CMOS transistors, namely an n-channel FET 51 and a p-channel FET 41, whose sources 34b' and 34b are electrically connected with the corresponding pad 37b. The drains of all the n-channel CMOS FETs on the same row are connected with a VDD line 48 of the row. The drains of the p-channel CMOS FETs on the same row are connected with a VSS line 49 of the row. The gates of all the p-channel and n-channel CMOS FETs on the same column are connected with a VGG line of the column. The VSS and the VDD lines are connected to a row driver 47 and supplied with control signals therefrom. The VGG lines 52 are connected to a column driver 46 and supplied with control signals therefrom. The column driver 46 and the row driver 47 are formed on the projected end of the glass substrate 11 as will be understood from the illustration of Fig. 2.

When a TN liquid crystal material is used, the distance between the substrates is selected to be about 10 μm and both the inner surfaces of the substrates are provided with orientation control films which are given a suitable rubbing treatment. When a ferroelectric liquid crystal (FLC) material is used, the distance between the substrates is selected to be about 1.5 to 3.5 μm, e.g. 2.3 μm and only one of the inner surfaces (the surface of the ground electrode) is provided with an orientation control film given a suitable rubbing treatment. The driving voltage is ±20V. When a liquid crystal material of dispersion type or a polymeric liquid crystal material is used, the distance between the substrates is selected to be about 1.0 to 10.0 μm, e.g. 2.3 μm, and no orientation control film is necessary. The driving voltage is ±10 to ±15V. In this case, polarization plates are also unnecessary and therefore the amount of available light can be relatively increased in either transmission or reflective types of LCD. Accordingly, whereas the liquid crystal layer possesses no threshold voltage, a large contrast in displayed images may be realized and undesirable cross-talk may be effectively prevented by the use of complementary TFTs which provide a definite threshold voltage.

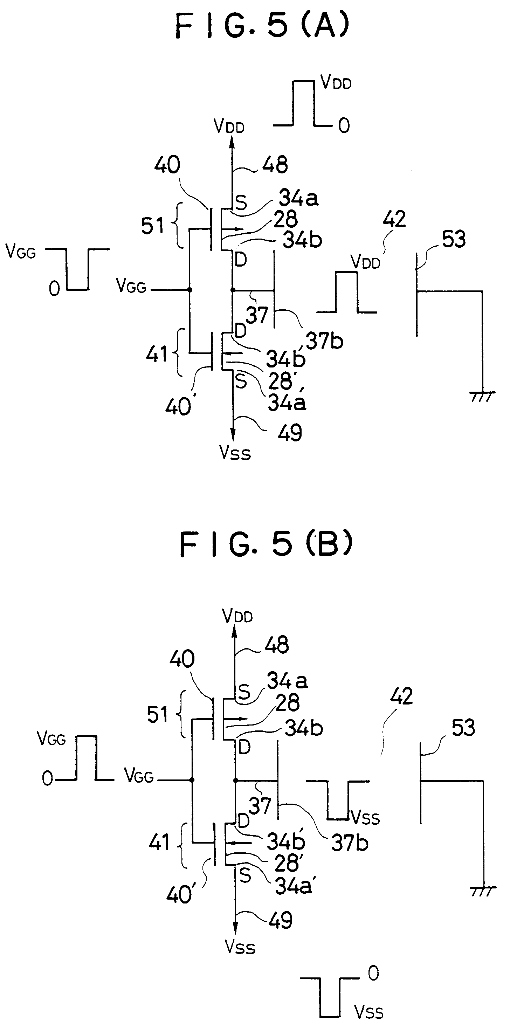

The operation of the complementary transistors will now be explained with reference to Fig. 5(A) and 5(B). Let the VDD line and the VSS line be +10V and -10V respectively. The n-channel transistor 51 is turned on and the p-channel transistor 41 turned off when a positive voltage VGG is applied to the gate terminals 40 and 40' as illustrated in Fig. 5(A). This output condition continues until the source voltage level reaches VGG-Vth. Namely, the n-channel transistor is turned off when the effective gate voltage (the gate voltage relative to the source voltage) becomes less than the threshold voltage Vth. Of course, the n-channel transistor always supplies electric charge to the source terminal in order to maintain the source voltage level at that level and to cope with current leakage from the source terminal. Accordingly, the source terminal, i.e. the output level of the complementary transistors is fixed to the VGG-Vth level so that the output level can be controlled by the input gate signal.

Conversely, the n-channel transistor 51 is turned off and the p-channel transistor 41 turned on when a negative voltage VGG is applied to the gate terminals 40 and 40' as illustrated in Fig. 5(B). this output condition continues until the source voltage level falls to VGG-Vth. Namely, the p-channel transistor is turned off when the effective gate voltage (the gate voltage relative to the source voltage) becomes lower in magnitude than the threshold voltage Vth. Of course, the n-channel transistor always discharges the source terminal in order to maintain the source voltage level at that level and to cope with current leakage from the source terminal. Accordingly, the source terminal, ie. the output level of the complementary transistors is fixed to the VGG-Vth level so that the output level can also be controlled by the input gate signal.

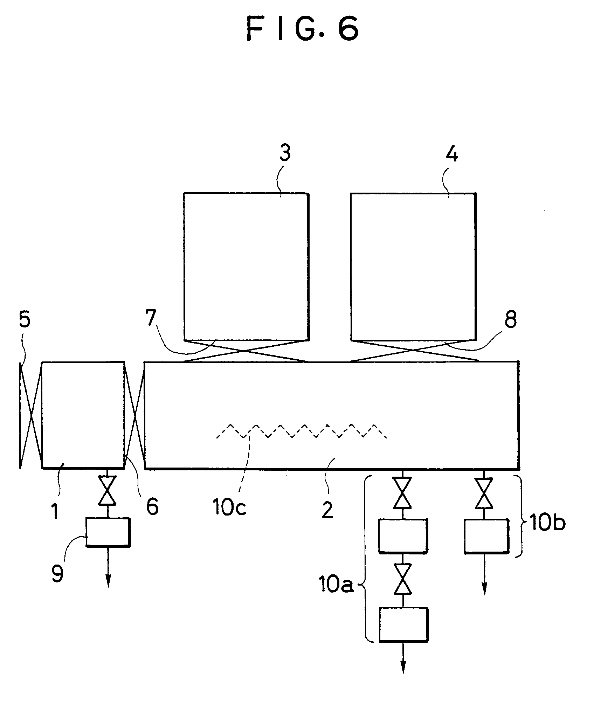

Referring now to Fig. 6, Figs. 7 (A) and 7 (B) and Figs. 8 (A) to 8 (F), a method of manufacturing CMOS insulated-gate field effect transistors 41 and 51 in accordance with a first embodiment of the present invention will now be explained. Fig. 6 is a schematic view showing a multi-chamber sputtering system for depositing semiconductor and oxide films by magnetron RF sputtering. The system comprises a loading and unloading chamber 1 provided with a gate valve 5, a subsidiary chamber 2 connected to the loading and unloading chamber 1 via a gate valve 6, and first and second individual sputtering apparatuses 3 and 4 respectively connected to the subsidiary chamber 2 through gate valves 7 and 8 respectively. The loading and unloading chamber 1 is provided with an evacuation system 9 comprising a rotary pump and a turbomolecular pump coupled in series. The subsidiary chamber 2 is provided with a first evacuation system 10a for roughing comprising a rotary pump and a turbomolecular pump in series, a second evacuation system 10b for high vacuum evacuation comprising a cryosorption pump and a heater 10c located in the subsidiary chamber 2 in order to heat the substrates to be coated. If substrates to be coated are thermally stabilized in advance by being heated in the subsidiary chamber 2, their thermal distortion and stress caused in films during deposition can be reduced thereby improving the adhesion of the films to the substrates.

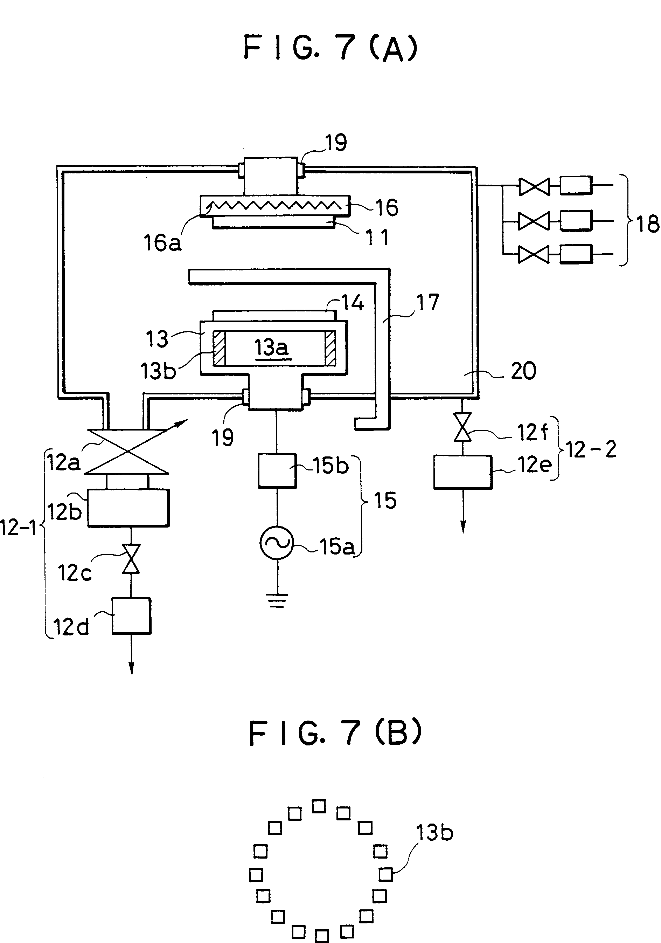

The sputtering apparatuses 3 and 4 are individual planar type magnetron RF sputtering apparatuses suitable for exclusive use in depositing oxide films and semiconductor films respectively when used in accordance with the present invention. Figs. 7(A) and 7(B) illustrate details of the RF sputtering apparatus. The apparatus comprises a vacuum chamber 20, a first evacuation system 12-1 for roughing consisting of a turbomolecular pump 12b and a rotary pump 12d provided with valves 12a and 12c respectively, a second evacuation system 12-2 for high vacuum evacuation comprising a cryosorption pump 12e provided with a valve 12f, a metallic holder 13 fixed in the lower section of the vacuum chamber 20 for supporting a target 14 thereon, the holder being formed with an inner conduit 13a through which a coolant can be caused to flow to cool the target 14 and being provided with a plurality of magnets 13b such as permanent magnets, an energy supply 15 consisting of an RF (e.g. 13.56MHz) source 15a provided with a matching box 15b for supplying RF energy to the holder 13, a substrate holder 16 located in the upper section of the vacuum chamber 20 for supporting a substrate 11 to be coated, a heater 16a embedded in the substrate holder 16, a shutter system 17 located between the substrate 11 and the target 14, and a gas supply system 18. A sealing means 19 is also provided for ensuring that the vacuum chamber 20 remains airtight. In advance of actual deposition on the substrate 11, impurities occurring in the targets are sputtered out and deposited on the shutter 17 which is positioned between the substrate 11 and the target 14, and then the shutter is removed in order to enable normal deposition to be effected on the substrate 11. The magnets 13b are oriented with their N poles at their upper ends and their S poles at their lower ends and are horizontally arranged in a circle as illustrated in Fig. 7(B) in order to confine electrons within a sputtering region between the substrate 11 and the target 14.

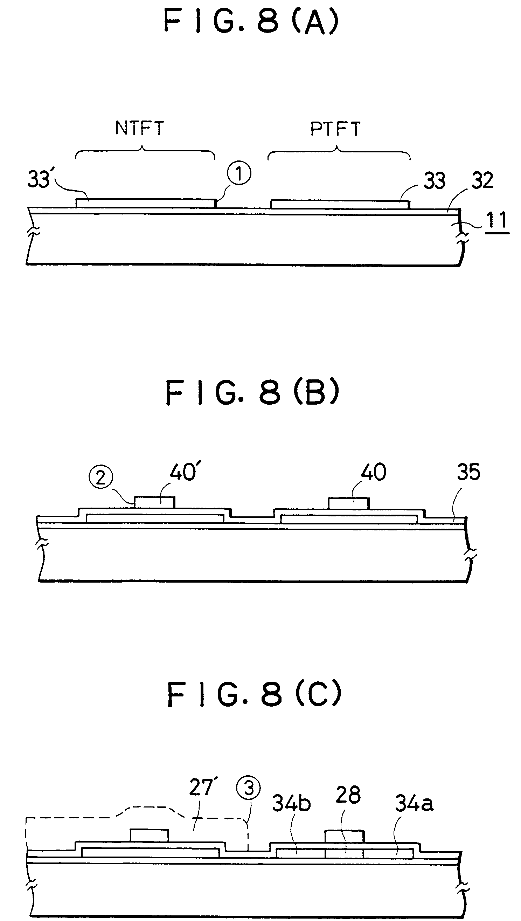

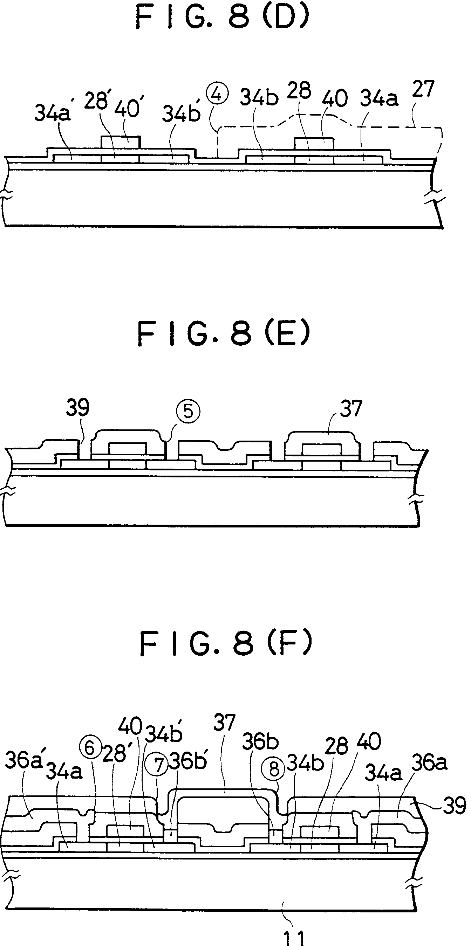

Referring now to Figs. 8(A) to 8(F) together with Fig. 6 and Figs. 7(A) and 7(B), a method of manufacturing thin-film field effect transistors 41 and 51 in accordance with the first preferred embodiment of the invention will now be described in detail. This exemplary method is carried out with a multi-chamber apparatus suitable for mass-production. However, the method is applicable to similar processes utilizing separate chambers without substantial modification. Ten sheets of glass substrate are mounted on a cassette and placed in the loading and unloading chamber 1 through the gate valve 5. The substrates may be made from an inexpensive glass which can endure thermal treatment at high temperatures up to 700°C, e.g. 600°C, such as NO glass manufactured by Nippon Electric Glass Co. Ltd., LE-30 glass manufactured by Hoya Co. or VYCOR glass manufactured by Corning Corp. After adjusting the inner conditions of the loading and unloading chamber 1 and the subsidiary chamber 2 to be equivalent, the cassette is transported from the loading and unloading chamber I into the subsidiary chamber 2 through the gate valve 6. One of the glass substrates is positioned in the first magnetron RF sputtering apparatus as shown in Fig. 7(A) by means of a transportation mechanism (not shown) and coated with a $SiO_2$ film 32 as a blocking film to a thickness of 1000Å to 3000Å. The conditions under which this deposition is carried out are given as: an atmosphere of 100% oxygen; a total atmospheric pressure of 0.5 Pa; a substrate temperature of 150°C; and a power output of 400W to 800W from the 13.56 MHz RF apparatus. The target is composed of a single crystalline silicon or a quartz block and the deposition speed is 30 to 100 Å/min. The coated substrate is then exchanged for one of the remaining substrates and this is subsequently coated with a $SiO_2$ film in the same manner. This process is repeated until all the substrates mounted on the cassette are coated with a $SiO_2$ film. During this procedure, the transportation of a substrate between the subsidiary chamber 2 and the sputtering apparatus 3 has to be carried out after adjusting the pressures and the inner atmospheres of the chambers 2 and 3 to be equivalent, so as to eliminate undesirable impurities.

An amorphous silicon film 33 is next deposited in the second sputtering apparatus 4 on the $SiO_2$ film 32 to a thickness of from 500 nm to 1 μm, e.g. 2000Å. The total density of oxygen, carbon and nitrogen in the amorphous film is preferably between $5 \times 10^{20}$ to $5 \times 10^{21} cm^{-3}$ in order to eliminate the undesirable influence of incident light on the channel region of the transistor by reducing its photosensitivity. The photosensitivity of the channel can alternatively be reduced by introducing a spoiling impurity selectively into the channel. In this case, it is desirable that the total density of oxygen, carbon and nitrogen in the amorphous film does not exceed $7 \times 10^{20} cm^{-3}$, and preferably that it does not exceed $1 \times 10^{19} cm^{-3}$. Such a low density makes it easy to recrystallize the source and the drain to be formed in the silicon film in a later step by thermal treatment. For the formation of the silicon film 33, the ten substrates are placed into the second sputtering apparatus 4 one after another from the subsidiary chamber 2 in the same manner as described previously and an amorphous silicon film is deposited on each substrate. The transportation of each substrate between the second sputtering apparatus 4 and the subsidiary chamber 2 is carried out after adjusting the pressures and the inner atmospheres of the chambers 2 and 4 in order to eliminate undesirable impurities. This procedure is generally employed when it is desired to transport the substrates between any two adjacent chambers, even if not particularly described hereinbelow. The atmosphere in the second sputtering apparatus 4 comprises a mixture consisting of hydrogen and argon so that the partial pressure of hydrogen is given as $H_2/(H_2+Ar) = 0.8$ (0.2 to 0.8 in general). The hydrogen and argon gases desirably have purities of 99.999% and 99.99% respectively and are introduced after the inside of the second sputtering apparatus 4 is evacuated to a pressure not higher than $1 \times 10^{-5}$ Pa. Deposition is carried out under a total atmospheric pressure of 0.5 Pa with the output power of the 13.56 MHz RF apparatus at 400W to 800W using a target composed of single crystalline silicon desirably containing oxygen atoms at a concentration of no greater than $5 \times 10^8 cm^{-3}$ (typically $1 \times 10^8 cm^{-3}$ and with the substrate temperature (deposition temperature maintained at 150°C by use of the heater 16a. In the preferred embodiments, the hydrogen proportion in the mixture may be chosen to be between 5% and 100%, the deposition temperature between 50°C and 500°C (typically 150°C) and the output power of the RF apparatus between 1W and 10MW in a frequency range from 500Hz to 1000Hz which in addition may be combined with another pulsed energy source.

Alternatively, the amorphous silicon film 33 may be deposited by low-pressure CVD (LPCVD) or plasma CVD. In the case of LPCVD, the deposition is carried out by introducing disilane ($Si_2H_6$) or trisilane ($Si_3H_8$) in a suitable CVD chamber. The deposition temperature is selected to be 100°C to 200°C lower than the recrystallization temperature of the silicon, i.e. 450°C to 550°C, for example 530°C. The deposition speed is 50 to 200Å/min. Boron may be introduced at a density of $1 \times 10^{15} cm^{-3}$ to $1 \times 10^{18} cm^{-3}$ into the film by using diborane as a dopant gas together with the silane in order to make the threshold voltages of N-type and P-type TFTs even. In the case of plasma CVD, the deposition is carried out by introduc-

ing monosilane ($SiH_4$) or disilane ($Si_2H_6$) at 300°C in a suitable plasma CVD chamber. the input energy is for example high-frequency electric energy at 13.56MHz.

The oxygen density of the semiconductor film is preferably no higher than $5 \times 10^{21} cm^{-3}$ because if the oxygen density is too high, thermal treatment has to be carried out at a high temperature for a long period of time in order to sufficiently recrystallize the semiconductor film in a later step. The oxygen density, however, must not be too low because leakage current in the off condition of the TFT increases in response to a back light which may be provided in the liquid crystal display if a particular spoiling impurity is not used. For this reason, the oxygen density is selected between $4 \times 10^{19}$ and $4 \times 10^{21} cm^{-3}$. It was confirmed by SIMS (secondary ion mass spectroscopy analysis) that a hydrogen impurity was present in this structure at a density of $4 \times 10^{20} cm^{-3}$ which is equivalent to one atom % assuming the density of silicon to be $4 \times 10^{22} cm^{-3}$. This density figure was a minimum value for hydrogen which varied along the depth direction. The reason why such a minimum value was used is because a natural oxide existed at the surface of the semiconductor film. If it is desired to dope the channel region, oxygen may be introduced as a spoiling agent to a portion of the semiconductor film to be a channel region to a density of $5 \times 10^{20}$ to $5 \times 10^{21} cm^{-3}$ after the deposition of the semiconductor film. In this case, the deposition of the semiconductor film can be carried out in order that the total density of oxygen in the semiconductor film does not exceed $7 \times 10^{20} cm^{-3}$, preferably that it does not exceed $1 \times 10^{19} cm^{-3}$. Such a low density makes it easy to recrystallize the source and drain regions of the semiconductor film in a later step by thermal treatment. In this case, when TFTs for the peripheral circuits which are located so as not to be exposed to any illumination are formed at the same time, the mobility of these TFTs can be increased, because the introduction of oxygen is prevented, resulting in a high speed of operation.

After all the substrates are coated with the silicon oxide and amorphous silicon semiconductor films, thermal treatment is given thereto in the subsidiary chamber 2 by means of the heater 10c at an operating temperature in the range 450°C to 700°C (typically 600°C) for a period of 12 to 70 hours using a non-oxidizing atmosphere, e.g. hydrogen. The film is recrystallized by this treatment (thermal annealing) and forms a semi-amorphous or semi-crystalline structure.

Next, the mechanism for the formation of semiamorphous or semi-crystalline semiconductor material in accordance with the present invention will be explained. When sputtering a single crystalline silicon target in a mixture of hydrogen and argon, high-energy heavy argon atoms collide with the surface of the target and dislodge therefrom clusters each containing several tens to several hundreds of thousands of silicon atoms, which are finally deposited on the substrate to be coated. These clusters pass through the mixture of gases in advance of the deposition on the substrate and react with hydrogen atoms at their external surfaces in order to terminate open ended or dangling bonds. Accordingly, when deposited on the substrate, the clusters comprise internal amorphous silicon and external ordered silicon including Si-H bonds. The Si-H bonds react with other Si-H bonds and are converted to Si-Si bonds by thermal treatment in the temperature range 450°C to 700°C in a non-oxidizing atmosphere. This coupling of adjacent silicon atoms (Si-Si) functions to let adjacent clusters be attracted to each other, whereas without thermal treatment these clusters have a tendency to convert their states to more ordered states (partial recrystallization). As a result of adjacent combinations, the crystalline structure of these clusters is given lattice distortion and the peak of its Raman spectra ($522cm^{-1}$: the peak of single crystalline silicon) is displaced in the low-frequency direction. The apparent grain diameter calculated on the basis of half-width is in the range 50Å to 500Å which seems to indicate the existence of microcrystals.

The energy bands of the clusters are connected through the Si-Si bonds thereby anchoring the clusters at the interfaces therebetween. For this reason, the polycrystalline (semi-amorphous or semi-crystalline) structure of silicon in accordance with the present invention, is entirely different than usual polycrystals in which grain boundaries provide barriers against carrier transportation, so that the carrier mobility of the polycrystalline silicon can be of the order of 15 to 300 $cm^2$/Vsec (electron mobility) and 10 to 200 $cm^2$/Vsec (hole mobility). Therefore, the semi-amorphous or semi-crystalline structure in accordance with the present invention can be considered substantially not to include undesirable grain boundaries. However, if the semiconductor is subjected to high temperatures of 1000°C or higher rather than the relatively low temperatures of 450°C to 700°C, latent oxygen atoms come to appear at the boundaries between the clusters and form barriers as in some of the prior art techniques. The carrier mobility can be improved by increasing the strength of the anchoring between the clusters. For this purpose, the oxygen density in the semiconductor film is decreased to 7 x $10^{19}cm^{-3}$, desirably to 1 x $10^{19}cm^{-3}$.

The amorphous silicon semiconductor film 33 is patterned by means of a photomask as indicated by ① in Fig. 8(A) to leave areas 33 and 33′ which are necessary to form N-channel and P-channel transistors. After all the substrates are coated with the silicon oxide and the amorphous silicon semiconductor film and patterned as described above, the substrates are placed again in the first sputtering apparatus 3. The entire structure is then coated with a silicon oxide film 35 of a thickness of 500Å to 2000Å, e.g. 1000Å, by sputtering in an oxide atmosphere as illustrated in Fig. 8(B). The deposition condition is the same as that for the silicon oxide film 32 as explained above. The characteristics at the interface between the silicon oxide film 35 and the underlying semiconductor film 33 can be improved by applying ultraviolet radiation to implement ozone oxidation. Namely, the interface states can be decreased by utilizing photo-CVD in combination with the sputtering explained in the description of deposition of the oxide film 32. Alternatively, fluorine may be introduced in this deposition in order to fix sodium ions. In this case, the atmosphere comprises a high density of oxygen (95%) including $NF_3$ (5%) at a total atmospheric pressure of 0.5 Pa, the output power of the 13.56 MHz RF apparatus is 400W, a target composed of a single crystalline silicon or an artificial quartz is used and the substrate temperature is maintained at 100°C. By this procedure, the silicon oxide film 35 for the gate insulating film includes fluorine atoms which function to terminate open ended or dangling bonds of silicon atoms so that the formation of fixed charge can be prevented at the interface between the semiconductor films 33 and 33′ and the oxide film 35. A silicon semiconductor film of 0.2 μm thickness which is highly doped with phosphorus at a density of 1 x $10^{21}$ to 5 x $10^{21}cm^{-3}$ is deposited by low-pressure CVD on the silicon oxide film 35 followed, if desired, by the coating of a single conductive film of 0.3 μm thickness made of molybdenum or tungsten or a multiple conductive film comprising the single conductive film previously described and a $MoSiO_2$ or $WSiO_2$ film. The semiconductor film coated with the single or multiple conductive film is then patterned by photolithography with a suitable mask as shown in Fig. 8(B) at ② in order to form gate electrodes 40 and 40′.

A photoresist film 27′ is formed by the use of a photomask as shown in Fig. 8(C) at ③ in order to cover the semiconductor film 33′. Using the gate electrode 40 and the photoresist film 27′, self-aligned impurity regions, i.e. a source and a drain region 34a and 34b are formed by ion implantation of boron at a density of 1 x $10^{15}cm^{-2}$ to 5 x $10^{15}cm^{-2}$. The resultant intermediate region 28 of the silicon semiconductor film 33 between the impurity regions 34a and 34b is then defined as a channel region as illustrated in Fig. 8(C). After removing photoresist film 27′, another photoresist film 27 is formed by the use of a photomask ④ in order to cover the semiconductor film 33. Using the gate electrode 40′ and the photoresist film 27′, self aligned impurity regions, i.e. a source and a drain region 34b′ and 34a′ are formed by ion implantation of phosphorus at a density of 1 x $10^{15}cm^{-2}$ to 5 x $10^{15}cm^{-2}$. The resultant intermediate region 28′ of the silicon semiconductor film 33 between the impurity regions 34a′ and 34b′ is then defined as a channel region as illustrated in Fig.8(D). The channel lengths of the p-channel and n-channel transistor are 10 µm respectively. The channel widths of the p-channel and n-channel transistor are 20 µm respectively. The ion implantation may instead be carried out by selectively removing the silicon oxide film 35 by the use of the gate electrode 40 or 40' as a mask followed by direct ion implantation of boron or phosphorus.

After removing the photoresist 27, the channel regions are subsequently thermally annealed at 600°C for 10 to 50 hours in an atmosphere of hydrogen to make the impurities in the drain and source regions active. An interlayer insulating film 37 of silicon oxide is deposited to a thickness of 0.2 to 0.6 µm by the same sputtering method as described above over the entire surface of the structure, followed by etching by means of a photomask ⑤ for opening contact holes 39 through the interlayer insulation film 37 and the oxide film 35 in order to provide access to the underlying source and drain regions 34b, 34a, 34b' and 34a'. The deposition of the interlayer insulating film 37 may be carried out by LPCVD, photo-CVD, ordinal-pressure CVD (TEOS-ozone). Next, an aluminium film of 0.5 to 1 µm thickness is deposited on the structure over the contact holes 39 and is patterned to form source and drain electrodes 36b, 36a, 36b' and 36a' by means of a photomask ⑥ as illustrated in Fig. 8(F). An organic resin film 39 such as a transparent polyimide film is coated over the structure to provide a planar surface and patterned by means of a photomask ⑦ to provide access to the source electrodes 36b and 36b'. This is then followed by the formation of lead electrode 37 made of a transparent conductive material such as indium tin oxide (ITO) which is to be electrically connected with the pad 37b. The ITO film is deposited by sputtering at room temperature to a temperature of 150°C followed by annealing in an oxidizing atmosphere ($O_2$) or in air at a temperature of 200°C to 400°C. The pad 37b can be formed at the same time by the deposition of the lead electrode 37. Then, the formation of the CMOS transistors is completed.

The mobility and the threshold voltage of the p-channel TFT are 20 cm$^2$/Vs and -5.9 V respectively. The mobility, the threshold voltage of the n-channel TFT are 40 cm$^2$/Vs and 5.0 V respectively. The glass substrate provided with these CMOS transistors incorporating suitable conductive patterns as illustrated, is joined with a counterpart glass substrate provided with a ground electrode located throughout its entire inner surface which followed by the injection of a liquid crystal material between these two substrates. One of the advantages of the above process is that the formation of these transistors (spoiled and not spoiled) can be carried out at temperatures no higher than 700°C so that the process does not require the use of expensive substrates such as quartz substrates and is therefore suitable for large scale LCD production methods.

In the above embodiment, thermal annealing is carried out twice at the steps corresponding to Figs. 8(A) and 8(D). The first annealing (Fig. 8(A)), however, can be omitted to shorten the process time because of the subsequent second annealing.

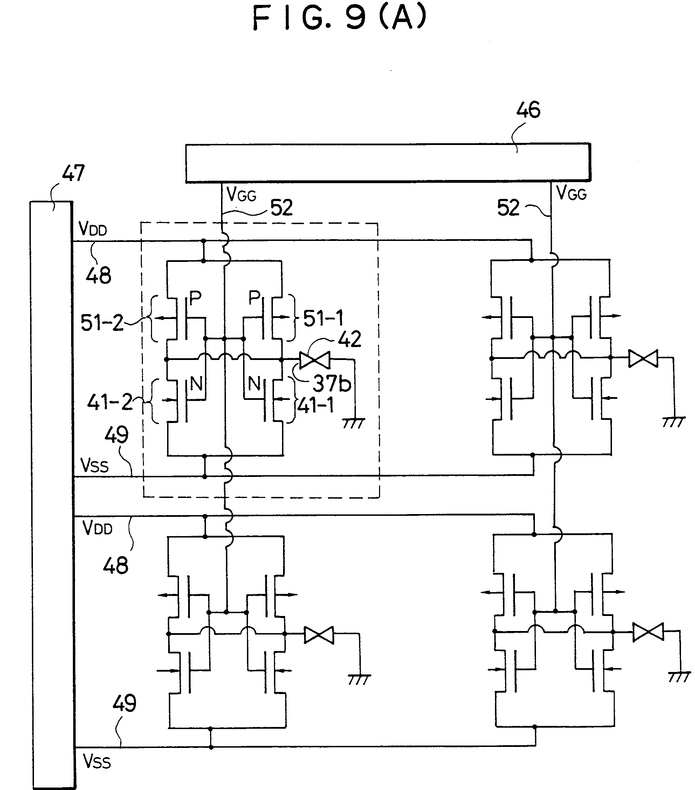

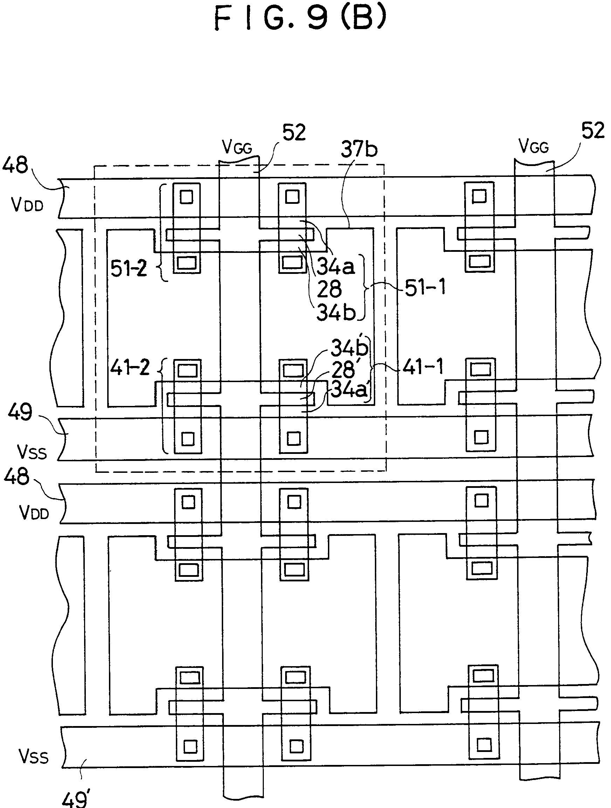

Referring to Figs. 9(A) and 9(B), CMOS thin-film field effect transistors in accordance with a second preferred embodiment of the present invention will now be described. In this embodiment, two pairs of complementary CMOS transistors 51-1 with 41-1 and 51-2 with 41-2 are connected in parallel to the conductive pad 37b for each pixel (as enclosed by the dashed line) at their source electrodes. These CMOS transistors are manufactured using the steps explained above in conjunction with the first embodiment except for the fact that the number of transistors is doubled. Similar elements are given similar numerals as in the first embodiment. The electrode pads 37b have to be deposited on the VGG line by use of a suitable insulating film therebetween. The electrical operation is substantially the same as that of the first embodiment. Accordingly, two identical individual switching elements are prepared corresponding to one pixel so that if the operation of one of them is at fault, the operation of the information display can be maintained by eradicating the faulty element by laser radiation without affecting the remaining CMOS transistors. For this reason, the conductive transparent pads are formed so as not to cover these TFTs.

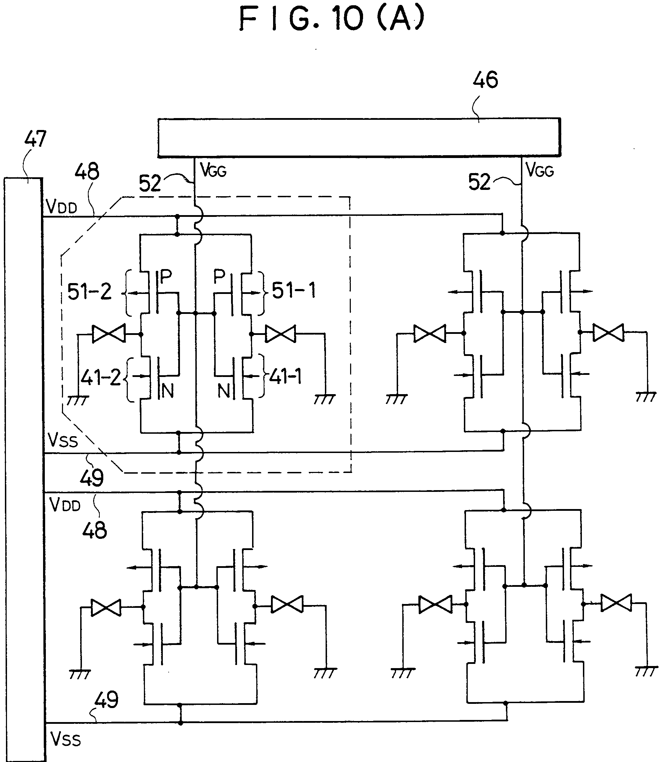

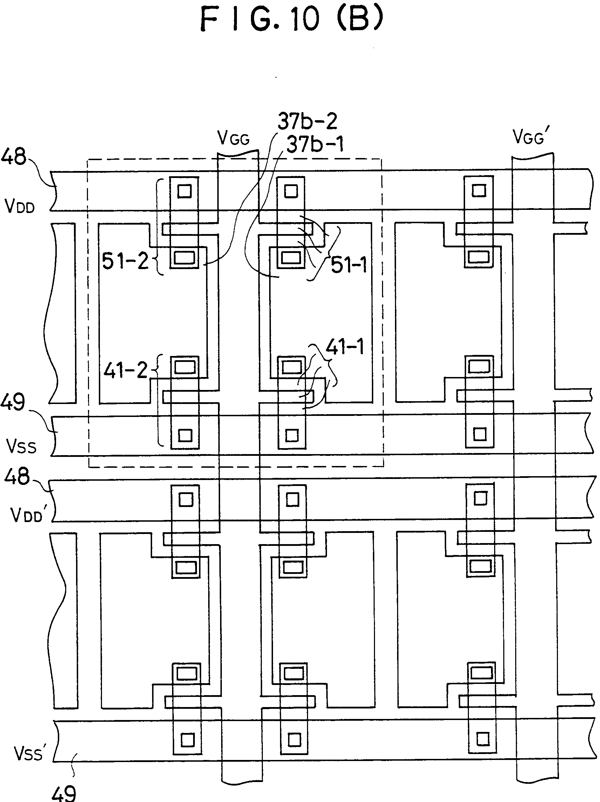

Referring to Figs. 10(A) and 10(B), CMOS thin-film field effect transistors in accordance with a third preferred embodiment of the present invention will now be described. Also in this embodiment, two pairs of complementary CMOS transistors 51-1 with 41-1 and 51-2 with 41-2 are connected in parallel to an electrode pad 37b for each pixel at their source electrodes. The electrode pad 37b, however, is separated into two portions 37b-1 and 37b-2 each independently connected to a corresponding one of the two CMOS transistors. These CMOS transistors are manufactured using the steps explained above in conjunction with the first embodiment except for the fact that the number of transistors is doubled. Similar elements are given similar numerals as in the first embodiment. Then, each pixel comprises two individual sub-pixels. In accordance with this embodiment, even if the operation of one of the sub-pixels is faulty, the other sub-pixel can support the operation of the pixel and therefore the deterioration of grey scales is substantially decreased.

As described above, there are the following advantages in accordance with the above embodiments of the present invention:

  1) Visual images can be constructed in a variety of grey shades;
  2) The voltage across the liquid crystal layer is stably fixed at a determinate level in accordance with the output signal from the complementary transistors rather than being in an indeterminate floating condition;

3) Margins for operational fluctuation are broadened;

4) Even if some TFTs are faulty, the operation of the embodiment is not prejudiced;

5) The increase of the number of photomasks used due to the employment of complementary transistors is limited to only two (photomask ③ and ④) as compared with conventional cases utilizing only n-channel TFTs; and

6) Since semi-amorphous or semi-crystalline semiconductors are used in place of amorphous semiconductors and the carrier mobility is increased by a factor of ten or more, the size of the TFT is substantially reduced so that only a slight decrease of the aperture ratio is necessary even when two TFTs are formed in one pixel.

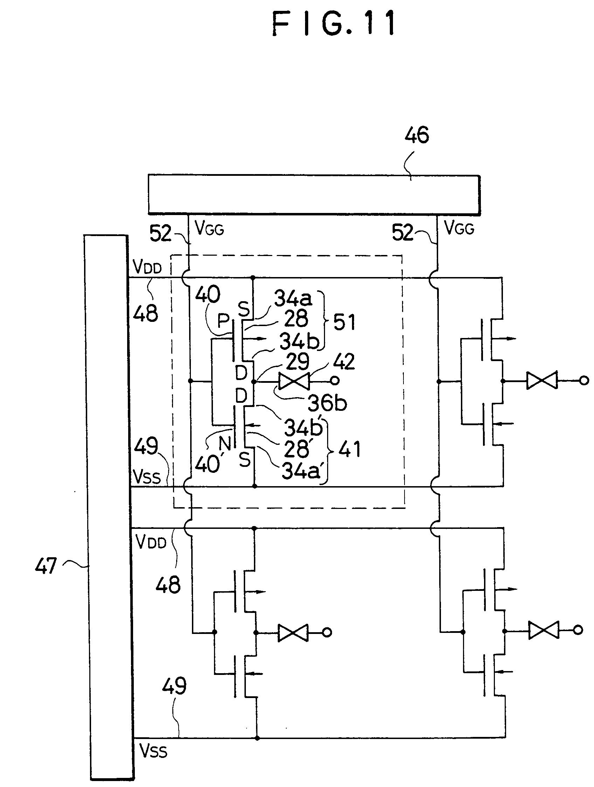

Fig. 11 is a diagram illustrating the equivalent circuit of a liquid crystal display in accordance with a fourth embodiment of the present invention. The pixel configuration as shown in Fig. 4 can be applied also for this embodiment. The diagram shows only a 2 x 2 matrix for convenience of description whereas ordinary liquid crystal displays consist of much greater numbers of pixels such as a 640 x 480 matrix or a 1260 x 960 matrix. The liquid crystal display includes a liquid crystal layer 42 disposed between a pair of glass substrates 11 and 11' in the same manner as the first embodiment as shown in Fig. 2. The entirety of the inner surface of the glass substrate 11' is coated with a back electrode 53. In this embodiment, however, the electrode 53 is not grounded but rather is supplied with an offset voltage in accordance with the driving mechanism of the liquid crystal display as explained in detail infra. The inner surface of the other substrate 11 is provided with a plurality of conductive pads 37b each constituting one pixel of the display in the same manner as the first embodiment. Each conductive pad 37b is formed on the substrate together with two CMOS transistors, namely an N-type FET 51 and a P-type FET 41, whose sources 34b' and 34b respectively are electrically connected with the corresponding pad 37b. The drains of all the N-type CMOS FETs on the same row are connected with a VDD line 48 of the row. The drains of all the P-type CMOS FETs on the same row are connected with a VSS line 49 of the row. The gates of all the P-type and N-type CMOS FETs on the same column are connected with a VGG line of the column. The VSS and VDD lines are connected to a row driver 47 and supplied with control signals therefrom. The VGG lines 52 are connected to a column driver 46 and supplied with control signals therefrom.

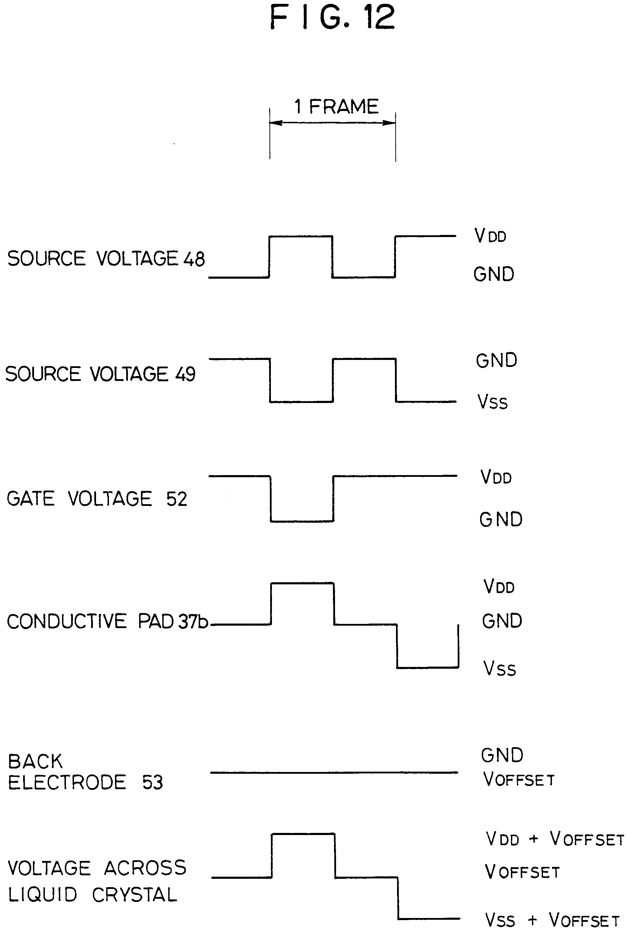

Fig. 12 illustrates the operational action of each pixel in response to several control signals applied to the VDD line, the VSS line, the VGG line and the back electrode. When a positive voltage is applied to the VDD line and a negative voltage to the VSS line, the liquid crystal voltage level at the pixel (i.e. the voltage level of the pad 37b) follows the voltage level at the VGG line and the liquid crystal voltage level is forcibly at ground if the VDD line and the VSS line are commonly grounded. Accordingly, the voltage applied between the liquid crystal at the pixel is calculated by subtracting the offset (bias) voltage applied to the back electrode from the liquid crystal voltage.

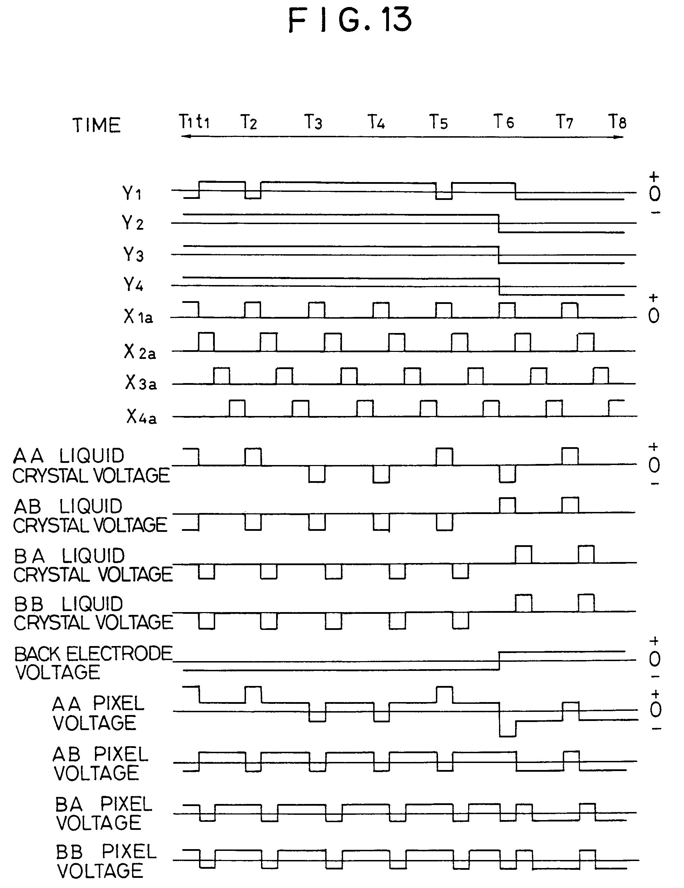

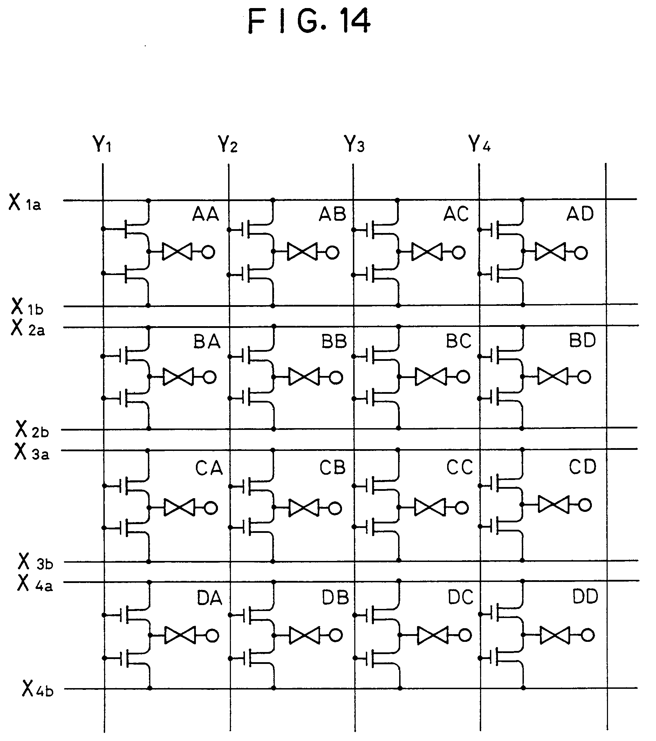

An example illustrating the driving method in accordance with the fourth embodiment of the present invention will now be explained with reference to Figs. 13 and 14. In Fig. 14, the 2 x 2 matrix of Fig. 11 is expanded to a 4 x 4 matrix. Their configurations, however, are substantially identical except for the number of pixels employed. Fig. 13 illustrates the control signals applied to the VDD lines, the VSS lines, the VGG lines and the back electrode. The VDD lines are called $X_{1a}$, $X_{2a}$, $X_{3a}$ and $X_{4a}$ from the first row to the fourth row in the diagram respectively whereas the VSS lines are called $X_{1b}$, $X_{2b}$, $X_{3b}$ and $X_{4b}$ in the same manner. The signals applied to the VSS lines are exactly the inverse of the signals applied to the VDD lines as shown in Fig. 12 and therefore, the waveforms of the VSS lines are not illustrated. The VGG lines are called $Y_1$, $Y_2$, $Y_3$ and $Y_4$ from the left column to the right column respectively. In this driving method, the control signals applied to the VDD and VSS lines are addressing signals which scan from the first row to the fourth row as shown in Fig. 13. Opposed pulses are applied to the VDD and VSS lines connected to one addressed row for a time interval equivalent to one quarter of the frame interval during which all the rows are sequentially scanned. The control signals applied to the VGG lines are data signals which determine the visual pattern appearing on the display.

If the actuation of a pixel on the i-th row and the j-th column is desired, a positive pulse is applied to the VGG line of the j-th column at the time when the i-th row is addressed by applying opposed pulses to the VDD and VSS lines on the i-th row. In Fig. 13, the pixel on the first column and the first row (given symbol AA in Fig. 14) is actuated in the first quarter of the first frame interval between $T_1$ and $T_2$, the second frame interval between $T_2$ and $T_3$ and the fifth frame interval between $T_5$ and $T_6$. The back electrode is biassed by a negative voltage between $T_1$ and $T_6$. The VDD, VSS and VGG signal levels and the bias voltage are for example 20V, -20V, ±20V and ±10V respectively in the case when the optical characteristic of the liquid crystal is changed by a threshold voltage of 20V thereacross. Accordingly, as understood from Fig. 12, a high voltage such as 30V is only applied to the selected pixel (the AA pixel in the figure) while the voltage level applied to the other pixel does not exceed 10V. In the time interval $T_6$ to $T_8$ in Fig. 13, the voltage levels on the VGG lines and the back electrode are inverted so that the polarity of the applied voltage on each pixel is simply inverted. Accordingly, a low voltage such as -30V is only applied to the selected pixel (the AA pixel in the figure) while the absolute voltage level applied to the other pixel does not exceed 10V. The pixel in the first column and the first row is actuated in the sixth frame between $T_6$ and $T_7$. The inversion of polarity takes place repeatedly once per several frames to several tens of frames, so that the average voltage applied to the liquid crystal approaches to zero volts throughout its operation resulting in the effective prevention of deterioration of the liquid crystal.

In accordance with this embodiment, the voltage level of control signals applied to the liquid crystal layer can be easily adjusted to the threshold level of the liquid crystal layer by simply adjusting the bias voltage level applied to the back electrode. The employment of the bias voltage makes it possible to cancel out the effect of the electric field impressed on the liquid crystal by periodically changing the polarity of the bias voltage, resulting in the prevention of electrolysis of the liquid crystal material.

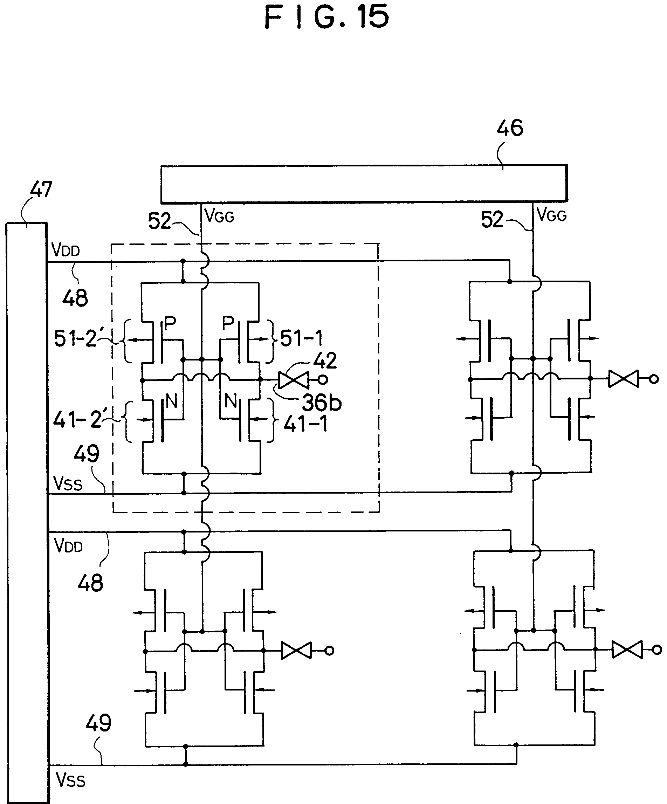

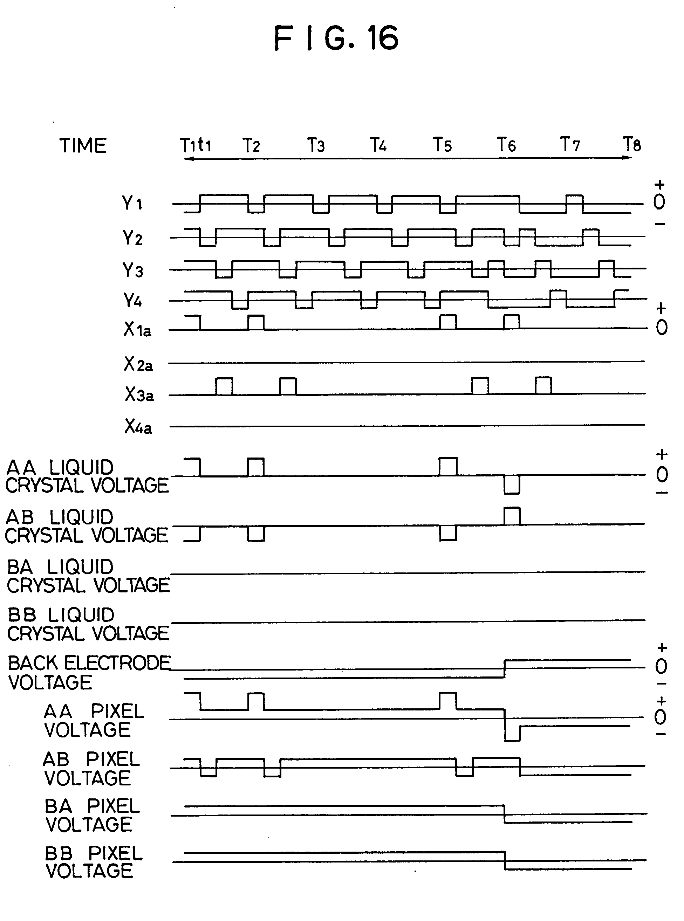

Referring to Figs. 15 and 16, a liquid crystal display and a method for driving the display in accordance with a fifth preferred embodiment of the present invention will now be described. In this embodiment, two pairs of complementary CMOS transistors 41-1 with 51-1 and 41-2 with 51-2 are connected in parallel to an electrode pad 36b for each pixel (as enclosed by the dashed line) at their source electrodes. These CMOS transistors are manufactured using the steps explained above in conjunction with the first embodiment except for the fact that the number of transistors is doubled. Similar elements are given similar numerals as in the first embodiment. The electrical operation is substantially the same as that of the third embodiment. Accordingly, two identical individual switching elements are prepared corresponding to one pixel so that when the operation of one of them is faulty, the operation of the information display can be maintained by eradicating the faulty element by laser radiation without prejudice to the operation of the remaining CMOS transistors. For this reason, the conductive transparent pads are formed so as not to cover these TFTs.

An example illustrating the driving method in accordance with the third embodiment of the present invention will now be explained with reference to Fig. 16. In Fig. 16, explanation is given for the operation of the display as shown in Fig. 15 but expanded in a 4 x 4 matrix. The configuration, however, is substantially identical except for the number of pixels employed. Fig. 16 illustrates the control signals applied to the VDD lines, the VSS lines, the VGG lines and the back electrode in the same manner as the second embodiment. In this driving method, the control signals applied to the VGG lines are addressing signals which repeatedly scan from the first row to the fourth row as shown in Fig. 16. A negative or positive pulse is applied to the VGG line connected to an addressed column. The opposed control signals applied to the VDD and VSS lines are data signals which determine the visual pattern appearing on the display.

If the actuation of a pixel on the i-th row and the j-th column is desired, opposed pulses are applied to the VDD and VSS lines of the i-th row at the time when the j-th column is addressed by applying a positive pulse to the VGG line on the j-th column. In Fig. 16, the pixel on the first column and the first row is actuated in the first frame interval between $T_1$ and $T_2$, the second frame interval between $T_2$ and $T_3$ and the fifth frame interval between $T_5$ and $T_6$. The back electrode is biassed by a negative voltage between $T_1$ and $T_6$. The VDD, VSS and VGG signal levels and the bias voltage are for example 20V, -20V, ±20V and ±10V respectively in the case when the optical characteristic of the liquid crystal is changed by a threshold voltage of 20V. Accordingly, as understood from Fig. 12, a high voltage such as 30V is only applied to the selected pixel while the voltage level applied to the other pixel does not exceed 10V. In the time interval $T_6$ to $T_8$ in Fig. 16, the voltage levels on the VGG lines and the back electrode are inverted so that the polarity of the applied voltage on each pixel is simply inverted. Accordingly, a low voltage such as -30V is only applied to the selected pixel while the absolute voltage level applied to the other pixel does not exceed 10V. The pixel in the first column and the first row is actuated in the sixth frame between $T_6$ and $T_7$. The inversion of polarity takes place repeatedly once per several frames to several tens of frames so that the average voltage applied to the liquid crystal approaches zero volts throughout its operation resulting in the effective prevention of deterioration of the liquid crystal.

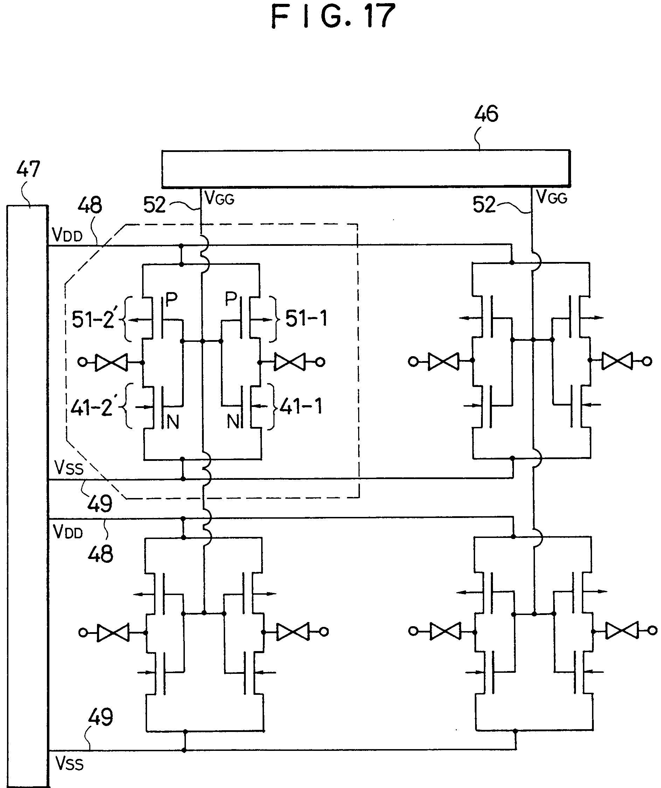

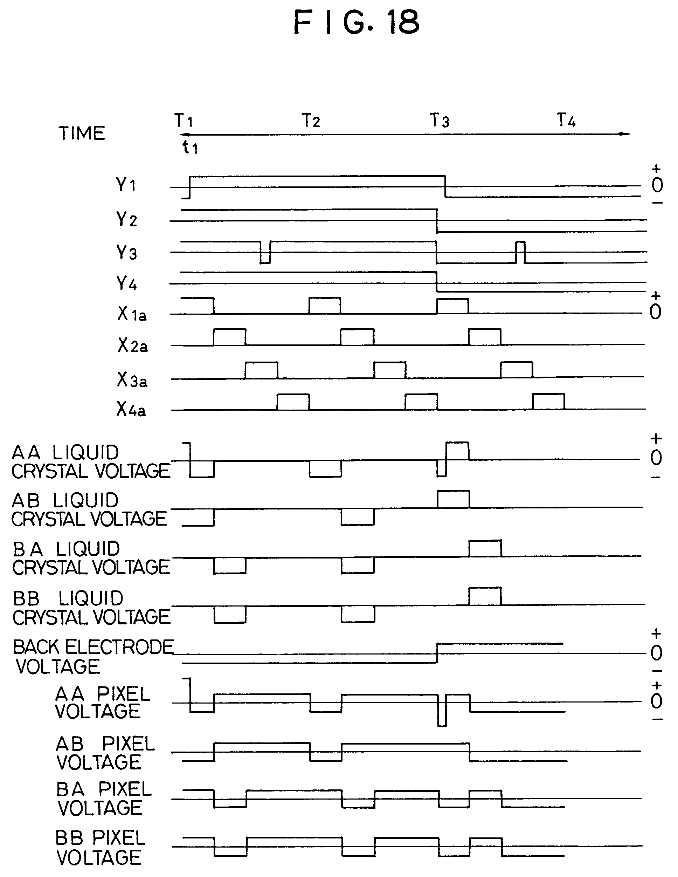

Referring to Figs. 17 and 18, a sixth preferred embodiment of the present invention will now be illustrated. Also in this embodiment, two pairs of complementary CMOS transistors 41-1 with 51-1 and 41-2 with 51-2 are connected in parallel to an electrode pad 37b for each pixel at their source electrodes. The electrode pad 37b, however, is separated into two portions 37b-1 and 37b-2 each independently connected to a corresponding one of the two CMOS transistors in the same manner as Fig. 10(B). These CMOS transistors are manufactured using the steps explained above in conjunction with the first embodiment except for the fact that the number of transistors is increased. Similar elements are given similar numerals as in the first embodiment. Then, each pixel comprises two individual sub-pixels. In accordance with this embodiment, even if the operation of one of the sub-pixels is faulty, the other sub-pixel can support the operation of the pixel and therefore the possibility of deterioration in grey scale is substantially decreased. Also even when the operational speed of one sub-pixel becomes low, the quality of the displayed image is not greatly deteriorated.

An example illustrating the driving method in accordance with the sixth embodiment of the present invention will now be explained with reference to Fig. 18. In Fig. 18, explanation is given for the operation of the display as shown in Fig. 17 but expanded in a 4 x 4 matrix. The configuration, however, is substantially identical except for the number of pixels employed. Fig. 18 illustrates the control signals applied to the VDD lines, the VSS lines, the VGG lines and the back electrode in the same manner as the fourth embodiment. In this driving method, the control signals applied to the VDD and VSS lines are addressing signals which scan from the first row to the fourth row as shown in Fig. 18. Opposed pulses are applied to the VDD and VSS lines connected to an addressed row. The control signals applied to the VGG lines are data signals which determine the visual pattern appearing on the display. In this embodiment, however, control signals applied to the VGG lines are positive or negative pulses whose pulse width is only one 16th of one frame interval (e.g. between $T_1$ and $T_2$). The pulse width of addressing signals applied to the VDD and VSS lines is on the other hand, one quarter of the frame interval in the same manner as the second embodiment. The use of 16th division is suitable for colour displays.

If the actuation of a pixel on the i-th row and the j-th column is desired, a positive pulse is applied to the VGG line of the j-th column at the time when the i-th row is addressed by applying opposed pulses to the VDD and VSS lines on the i-th row. In Fig. 18, the pixel on the first column and the first row is actuated in the first frame interval between $T_1$ and $T_2$. The back electrode is biassed by a negative voltage between $T_1$ and $T_3$. The VDD, VSS and VGG signal levels and the bias voltage are for example 20V, -20V, +20V and +10V respectively in the case when the optical characteristic of the liquid crystal is changed by a threshold voltage of 20V in the same manner as previously stated. Accordingly, as understood from Fig.18, a high voltage such as 30V is only applied to the selected pixel while the voltage level applied to the other pixel does not exceed 10V. In the time interval $T_3$ to $T_4$ in Fig.18, the voltage levels on the VGG lines and the back electrode are inverted so that the polarity of the applied voltage on each pixel is simply inverted. Accordingly, a low voltage such as -30V is only applied to the selected pixel while the absolute voltage level applied to the other pixel does not exceed 10V. The pixel in the first column and the first row is actuated in the third frame between $T_3$ and $T_4$. The inversion of polarity takes place repeatedly once per several frames to several tens of frames so that the average voltage applied to the liquid crystal approaches zero volts throughout its operation resulting in the effective prevention of deterioration of the liquid crystal.

The foregoing description of preferred embodiments has been presented for purposes of illustration and description. It is not intended to be exhaustive or to limit the invention to the precise form described, and obviously many modifications and variations are possible without departure from the scope of the invention.

The above embodiments are applications using CMOS technology for switching devices in liquid crystal displays. The TFT in accordance with the present invention, however, can be utilized in the form of a switching device comprising one TFT for driving one pixel. In this case, the equivalent circuit would be substantially the same as that illustrated in Fig.1 except that the resistance RSD would not be effective because the n-type TFT is contructed with a doped semiconductor film which is not sensitive to incident light as explained above. The electrode pad of each pixel becomes electrically floating when not addressed in this modification so that the voltage level thereof may not always be fixed as compared with those utilizing CMOS technology. The manufacturing process thereof, however, is very simple without the need of light blocking means.

The liquid crystal material used in the liquid crystal display may include other types of materials. For example, a suitable phase transition liquid crystal material can be prepared by adding an ion dopant into a nematic liquid crystal material of guest-host type or dielectric anisotropic type. The phase transition liquid crystal material changes its optical appearance from a transparent state to a cloudy state and vice versa through a phase transition between its nematic phase and its cholesteric phase in accordance with application of an electric field. Furthermore, in place of liquid crystals, suitable light influencing materials may also be utilized for the same purpose such as electrophoresis dispersions which are prepared by dispersing pigment particles in an organic liquid which has been colored by a dye. If a grey scale is desired, a plurality of frame intervals are given to one image to be displayed and the selected pixels are actuated in fewer frame intervals than given in accordance with the desired grey tone.

The present invention can be applied to displays utilizing other types of semiconductor devices such as germanium or silicon/germanium ($Si_xGe_x$) semiconductor devices, in which case the thermal treatment can be done at temperatures approximately 100°C lower than those used for silicon semiconductors in the above embodiments. The deposition of such a semiconductor can be carried out by sputtering in a high-energy hydrogen plasma caused by optical energy (shorter than 1000 nm wavelength) or by electron cyclotron resonance (ECR). Instead of gases including hydrogen molecules, some hydrogen compounds can be used as the atmosphere for sputtering as long as they do not introduce additional impurities. For example, monosilane or disilane may be used for forming silicon semiconductor transistors. Although in the preferred embodiments oxide and semiconductor films are deposited respectively in separate apparatuses, it is also possible to deposit other types of gate insulating films or gate electrodes in a common apparatus. During deposition of oxide films, a halogen such as fluorine may be used as a sputtering atmosphere so as to introduce halogen atoms into the oxide films in order to effectively prevent alkali metal atoms from getting into the film from the glass substrate by virtue of neutralization. The same effect can be expected by the introduction of phosphorus in place of a halogen.

The present invention can be applied to other types of optical devices utilizing semiconductor devices such as image sensors, load elements or three-dimensional elements of monolithic integrated semiconductor devices. In the preferred embodiments field effect transistors are formed on a glass substrate. However, other substrates can be used instead. For example, thin-film field effect transistors may be formed on a silicon substrate in a liquid crystal display or an image sensor device. This silicon substrate may be an intrinsic silicon substrate, a p-type silicon substrate, an n-type silicon substrate, or a silicon substrate in which MOSFETs, bipolar transistors, or the like are provided in integrated circuit form. An insulating layer is provided between such a substrate and the thin-film field effect transistors although such an insulating layer may be dispensed with in the case of an intrinsic silicon substrate.

A gate electrode may be either a single layer electrode or a multi-layer electrode in a gate insulated field effect transistor in accordance with the present invention. The single layer gate electrode may be a silicon electrode doped with phosphorus or an aluminium electrode. The multi-layer gate electrode may be a two-layer electrode which consists of a lower chromium layer and an upper aluminium layer formed thereon or a two-layer electrode which consists of a lower silicon layer doped with phosphorus and an upper metallic or metal silicide layer formed thereon. The aluminium single layer electrode and the upper aluminium layer can be formed by sputtering an aluminium target. The silicon single layer electrode and the lower silicon layer can be formed by low-pressure CVD or by sputtering a silicon target doped with phosphorus. The lower chromium layer can be formed by sputtering a chromium target. The metallic layer may be a molybdenum layer formed by sputtering a molybdenum target, a wolfram layer formed by sputtering a wolfram target, a titanium layer formed by sputtering a titanium target, or an aluminium layer formed by sputtering an aluminium target. The metal silicide layer may be a $MoSi_2$ layer formed by sputtering a $MoSi_2$ target, a $WSi_2$ layer formed by sputtering a

$WSi_2$ target, or a $TiSi_2$ layer formed by sputtering a $TiSi_2$ target. Although the production methods described infra include several steps, the order of these steps can be changed.

## Claims

1. An electro-optical device comprising:
   a light influencing layer;
   an electrode located adjacent to said layer at one side of said layer in order to define a pixel in said layer;
   an n-channel field effect transistor connected to said electrode at its source terminal;
   a p-channel field effect transistor connected to said electrode at its source terminal;
   a first control line connected to the drain terminal of said n-channel field effect transistor;
   a second control line connected to the drain terminal of said p-channel field effect transistor;
   a third control line connected to the gate terminals of said n-channel field effect transistor and said p-channel field effect transistor; and
   a control circuit for supplying control signals to said first, second and third control lines.

2. An electro-optical device as claimed in claim 1 wherein said layer is a liquid crystal layer.

3. An electro-optical device as claimed in claim 1 or 2 wherein said electrode is provided in the form of a plurality of individual pads which are arranged in a matrix, each pad defining one individual pixel.

4. An electro-optical device as claimed in claim 1 or 2 or 3 further comprising a back electrode adjacent to said layer and at the other side of said layer for enabling the application of a voltage between said back electrode and said electrode pads.

5. An electro-optical device as claimed in any preceding claim wherein said electro-optical device is a display.

6. A method of operating an electro-optical device comprising: a light influencing layer; an electrode pad located adjacent to said layer at one side of said layer in order to define a pixel in said layer; an n-channel field effect transistor connected to said electrode pad at its source terminal; a p-channel field effect transistor connected to said electrode pad at its source terminal; a first control line connected to the drain terminal of said n-channel field effect transistor; a second ,control line connected to the drain terminal of said n-channel field effect transistor; a second ,control line connected to the drain terminal of said p-channel field effect transistor; a third control line connected to the gate terminals of said n-channel field effect transistor and said p-channel field effect transistor; and a control circuit for supplying control signals to said first, second and third control lines; said method comprising:

supplying a first voltage level to the drain terminal of said n-channel field effect transistor through said first control line;

supplying a second voltage level to the drain terminal of said p-channel field effect transistor through said second control line, said second voltage level being lower than said first voltage level; and

supplying a third voltage level to the gate terminals of said n-channel field effect transistor and said p-channel field effect transistor, said third voltage level being between said second voltage level with the deduction of the threshold voltage of said p-channel transistor and said first voltage level with the addition of the threshold voltage of said n-channel transistor.

7. A method as claimed in claim 6 wherein said first voltage level is positive with respect to a ground level.

8. A method as claimed in claim 6 wherein said second voltage level is negative with respect to a ground level.

9. A method as claimed in claim 6 wherein said electrode is provided in the form of a plurality of individual pads which are arranged in a matrix; said n-channel field effect transistor and said p-channel field effect transistor are provided individually as a pair of transistors for each pad; said first and second control lines are provided individually as a pair for each row; and said third control line is provided individually as one for each column; and wherein one row is addressed, during the driving of said electro-optical device, by supplying said first voltage level to the drain terminal of said n-channel field effect transistor through said first control line and supplying said second voltage level to the drain terminal of said p-channel field effect transistor through said second control line with respect to the addressed row; and data signals are supplied to said third control line of each column in order to actuate selected pixels by supplying said third voltage level to the gate terminals of said n-channel field effect transistor and said p-channel field effect transistor of the selected pixels.

10. A method as claimed in claim 6 wherein said electrode is provided in the form of a plurality of individual pads which are arranged in a matrix; said n-channel field effect transistor and said p-channel field effect transistor are provided individually as a pair of transistors for each pad; said first and second control lines are provided individually as a pair for each row; and said third control line is provided individually as one for each column; and wherein one column is addressed, during the driving of said electro-optical device, by supplying said third voltage level to the gate terminals of said n-channel field effect transistor and said p-channel field effect transistor of the addressed column; and data signals are supplied to said first and second control lines of each row in order to actuate selected pixels by supplying said first voltage level to the drain terminal of said n-channel field effect transistor through said first control line and supplying said second voltage level to the drain terminal of said p-channel field effect transistor through said second control line with respect to the selected pixels.

11. A method as claimed in any of claims 6 to 10 wherein said electro-optical device is a display.

12. A method of driving an electro-optical device comprising: a light influencing layer; an electrode pad located adjacent to said layer at one side of said layer in order to define a pixel in said layer; an n-channel field effect transistor connected to said electrode pad at its source terminal; a p-channel field effect transistor connected to said electrode pad at its source terminal; a first control line connected to the drain terminal of said n-channel field effect transistor; a second control line connected to the drain terminal of said p-channel field effect transistor; a third control line connected to the gate terminals of said n-channel field effect transistor and said p-channel field effect transistor; and a control circuit for supplying control signals to said first, second and third control lines, said method comprising:

supplying a first voltage level to the drain terminal of said n-channel field effect transistor through said first control line;

supplying a second voltage level to the drain terminal of said p-channel field effect transistor through said second control line, said second voltage level being lower than said first voltage level; and

supplying a third voltage level to the gate terminals of said n-channel field effect transistor and said p-channel field effect transistor.

13. A method as claimed in claim 12 wherein said first voltage level is positive with respect to a ground level.

14. A method as claimed in claim 12 wherein said second voltage level is negative with respect to a ground level.

15. A method as claimed in claim 12 or 13 or 14 wherein said electro-optical device is a display.

16. A method as claimed in claim 12 wherein said electrode is provided in the form of a plurality of individual pads which are arranged in a matrix; said n-channel field effect transistor and said p-channel field effect transistor are provided individually as a pair of transistors for each pad; said first and second control line are provided individually as a pair for each row; and said third control line is provided individually as one for each column; and wherein one row is addressed, during the driving of said electro-optical device, by supplying said first voltage level to the drain terminal of said n-channel field effect transistor through said first control line and supplying said second voltage level to the drain terminal of said p-channel field effect transistor through said second control line with respect to the addressed row; and data signals are supplied to said third control line of each column in order to activate selected pixels by supplying said third voltage level to the gate terminals of said n-channel field effect transistor and said p-channel field effect transistor of the selected pixels.

17. A method as claimed in claim 12 wherein said electrode is provided in the form of a plurality of individual pads which are arranged in a matrix; said n-channel field effect transistor and said p-channel field effect transistor are provided individually as a pair of transistors for each pad; said first and second control line are provided individually as a pair for each row; and said third control line is provided individually as one for each column; and wherein one column is addressed, during the driving of said electro-optical device, by supplying said third voltage level to the gate terminals of said n-channel field effect transistor and said p-channel field effect transistor of the addressed column; and data signals are supplied to said first and second control lines of each row in order to actuate selected pixels by supplying said first voltage level to the drain terminal of said n-channel field effect transistor through said first control line and supplying said second voltage level to the drain terminal of said p-channel field effect transistor through said second control line with respect to the selected pixels.

# F I G. 1

# F I G. 2

# F I G. 3

# F I G. 4 (A)

# F I G. 4 (C)

# F I G. 4 (B)

EP 0 488 643 A2

# F I G. 5 (A)

# F I G. 5 (B)

18

# F I G. 6

# F I G. 7 (A)

# F I G. 7 (B)

# F I G. 8 (A)

NTFT　　　　PTFT

33′　　　　①　　　　33　32

11

# F I G. 8 (B)

②　　40′　　　40　　35

# F I G. 8 (C)

27′　③　34b　28　34a

# F I G. 8 (D)

# F I G. 8 (E)

# F I G. 8 (F)

# F I G. 9 (A)

# FIG. 9(B)

# F I G. 10 (A)

# F I G. 10 (B)

# F I G. 11

# F I G. 12

# F I G. 13

TIME

T1 t1  T2  T3  T4  T5  T6  T7  T8

Y1

Y2

Y3

Y4

X1a

X2a

X3a

X4a

AA LIQUID
CRYSTAL VOLTAGE

AB LIQUID
CRYSTAL VOLTAGE

BA LIQUID
CRYSTAL VOLTAGE

BB LIQUID
CRYSTAL VOLTAGE

BACK ELECTRODE
VOLTAGE

AA PIXEL
VOLTAGE

AB PIXEL
VOLTAGE

BA PIXEL
VOLTAGE

BB PIXEL
VOLTAGE

# F I G. 14

# F I G. 15

# F I G. 16

| TIME | T1 t1 | T2 | T3 | T4 | T5 | T6 | T7 | T8 |

Y1

Y2

Y3

Y4

X1a

X2a

X3a

X4a

AA LIQUID CRYSTAL VOLTAGE

AB LIQUID CRYSTAL VOLTAGE

BA LIQUID CRYSTAL VOLTAGE

BB LIQUID CRYSTAL VOLTAGE

BACK ELECTRODE VOLTAGE

AA PIXEL VOLTAGE

AB PIXEL VOLTAGE

BA PIXEL VOLTAGE

BB PIXEL VOLTAGE

32

# F I G. 17

EP 0 488 643 A2

# F I G. 18

34